# EUROPEAN PATENT SPECIFICATION

(11) **EP 0 531 542 B1**
(45) Date of publication and mention of the grant of the patent: **10.01.1996**
(21) Application number: 92907343.5
(22) Date of filing: 26.03.1992
(51) Int. Cl.: H01S 3/18

(54) **Surface emitting type semiconductor laser and its fabrication method**
Senkrecht zur Oberfläche emittierender Halbleiterlaser und Verfahren zu seiner Herstellung
Laser à semi-conducteur du type à émission de surface et procédé pour sa fabrication

(30) Priority: 28.03.1991 JP 64872/91; 11.03.1992 JP 52642/92
(43) Date of publication of application: 17.03.1993
(73) Proprietor: SEIKO EPSON CORPORATION, Shinjuku-ku Tokyo 163 (JP)
(72) Inventor: MORI, Katsumi, 3-5, Owa 3-chome, Nagano-ken 392 (JP); ASAKA, Tatsuya, 3-5, Owa 3-chome, Nagano-kken 392 (JP); IWANO, Hideaki, 3-5, Owa 3-chome, Nagano-ken 392 (JP)
(74) Representative: Hoffmann, Eckart, Dipl.-Ing.
(86) International application number: PCT/JP92/00367
(87) International publication number: WO 92/17925

(56) References cited:
- EP-A- 0 475 371
- JP-A- 1 264 285
- JP-A- 3 018 835
- US-A- 4 949 350
- JOURNAL OF CRYSTAL GROWTH vol. 107, no. 1/4, 1 January 1991, Amsterdam,NL,pages 790 - 795 , XP246689 R.D. DUPUIS et al.:"In0.47Ga0.53As-InP Heterostructures for Vertical Cavity Surface Emitting Lasers at 1.65 um Wavelength"
- PATENT ABSTRACTS OF JAPAN vol. 12, no. 402 (E-673)25 October 1988;& JP-A-63142879
- PATENT ABSTRACTS OF JAPAN vol. 17, no. 85 (E-1322)19 February 1993;& JP-A-04280693

## Description

This invention concerns a surface emitting semiconductor laser that emits laser light in a vertical direction on a substrate and concerns the manufacturing process of that surface emitting semiconductor laser.

The applicants have proposed a surface emitting semiconductor laser with a buried optical resonator that uses a group II-VI compound semiconductor (EP-A-0 475 371, prior art according to Art. 54(3) EPC).

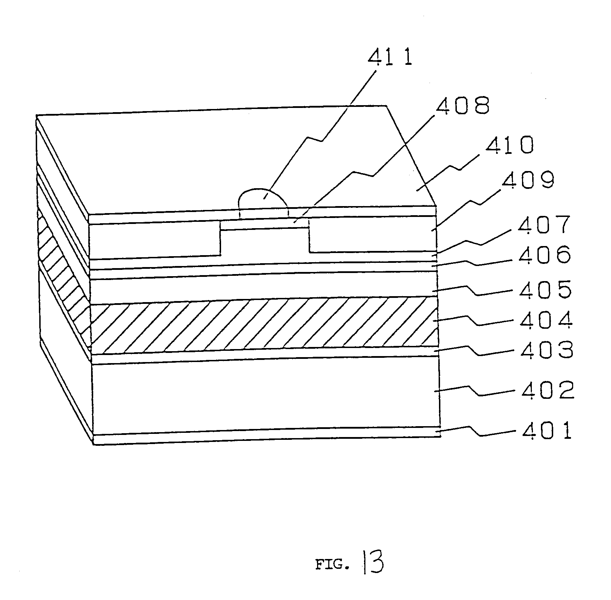

As indicated in Fig. 13, this surface emitting semiconductor laser is composed of an n-type GaAs buffer layer 403, a distributed Bragg reflection type multiple layer mirror 404, an n-type Al_{0.4} Ga_{0.6} As cladding layer 405, a p-type GaAs active layer 406, a p-type Al_{0.4} Ga_{0.6} As cladding layer 407, and a p-type Al_{0.1} Ga_{0.9} As contact layer 408. These are grown in sequence on an n-type GaAs substrate 402. After this, a p-type Al_{0.4} Ga_{0.6} As cladding layer 407, a p-type Al_{0.1} Ga_{0.9} As contact layer 408 are left in a column shaped region, which is etched vertically. Then, a ZnS_{0.06} Se_{0.94} layer 409 is buried around the circumference of this column shaped region. After this, a multi-layer mirror 411 is deposited in a region that is slightly smaller than the diameter of the column shaped region on the surface of the p-type Al_{0.1} Ga_{0.9} As contact layer 408.

This semiconductor laser further has a p-type ohmic electrode 410 and a n-type ohmic electrode 401. Since the ZnS_{0.06} Se_{0.94} 409 used in the buried layer has a high resistance and low refractive index, the confinement of current and light take place efficiently, creating a high performance surface emitting semiconductor laser.

However, there are problems with this technology. The in-flow of current to the active layer takes place through the distributed Bragg reflection mirror. The distributed Bragg reflection mirror has AlGaAs layers with a large energy bandgap and a high aluminum content. Also, these layers are stacked alternately with AlGaAs layers that have a large bandgap and a large aluminum content and a small bandgap and a low aluminum content. This results in an energy band structure that is not continuous and resistance that is high, making it difficult for current to flow. As a result, the element resistance of the surface emitting semiconductor laser increases and it heats up easily, allowing for inadequate reliability of the element, causing an increase in the threshold current and making high speed modulation difficult.

To resolve these problems, the applicants applied a high concentration of dopant to the entire distributed Bragg reflection mirror to bring down the element resistance. However, a new problem arose. The film quality of the layer that makes up the distributed Bragg reflection mirror deteriorated and the laser characteristics were lost.

In addition, on pages 2496 to 2498 of the Applied Physics Letter, number 56, 1990, Tai, et al, attempted to resolve the same type of problem by fabricating a layer with an intermediate energy bandgap between the bandgaps of the two types of layers that form the distributed Bragg reflection mirror. However, when the applicants examined this method of resolution, the following new problems arose:
(1) Because three or more layers with different compositions have to be stacked when fabricating the distributed Bragg reflection mirror, the manufacturing process becomes complicated, causing a reduction in yield and a lack of uniform properties.
(2) By fabricating a layer that has an intermediate bandgap, the hetero-barrier of the energy band is relieved. However, because this steepens the refractive index distribution at the same time, among the distributed Bragg reflection mirror portions with the same number of layers, there is a reduction in the reflection power of those mirror portions with the intermediate layer. This causes a deterioration in certain areas, for example, a rise in the threshold current of the surface emitting semiconductor laser.

For these reasons, the purpose of this invention is to resolve such problems. Its objective is to offer a surface emitting semiconductor laser that is highly efficient and highly reliable and to offer a manufacturing process that fabricates this laser by means of simple manufacturing process steps.

These objectives are achieved with a surface emitting laser as claimed in claim 1 and a manufacturing process as claimed in claim 8, respectively.

Specific embodiments of the invention are subject-matter of the dependent claims.

In the manufacturing process, when increasing the carrier concentration of the interface region, it is desirable to change the supply volume of the group III material and that of the group V material at the same time. Doing this will allow the formation of a hetero-interface between the first layer and the second layer that form the multiple layers of the distributed Bragg reflection multiple layer mirror. Or, it will allow the formation of high carrier concentration areas on the hetero-interface between the third layer and the fourth layer. This will improve the non-continuous band structure by increasing the tunnel conductance of the electrons and holes, which will allow for the formation of a distributed Bragg reflection multiple layer mirror with extremely low resistance. In addition, there will be no major change in the refractive index distribution. So, there also will be no reduction in the reflection power of the mirror. This will cause the element resistance to drop and allow a surface emitting semiconductor laser with low heat, high-speed operation and high reliability to be offered.

In addition, using the manufacturing process of this invention, the dopant material may be temporarily increased, light may be temporarily placed on the growth surface, the group V material and the group III material may be temporarily changed and the carrier concentration may be increased in the desired interface regions only. As for the methods involved, the operations are extremely simple and the manufacturing process takes place very stably and with good repeatability.
- Fig. 1: is an angular drawing showing a cross section of the semiconductor laser related to this invention.
- Figures 2 (a) through 2 (e): show cross sections of the manufacturing process related to the first embodiment of this invention.
- Fig. 3: is a timing chart showing the changes in the flow rates of TMGa, TMAI and H₂Se when the distributed Bragg reflection multiple layer mirror is grown in the first embodiment of this invention.
- Fig. 4: is a drawing that shows the results of evaluating a portion of the distributed Bragg reflection multiple layer mirror in the first embodiment of this invention by means of the SIMS method (secondary ion mass spectrometry).
- Fig. 5: is a drawing of the bands of the distributed Bragg reflection multiple layer mirror in the first embodiment of this invention. Fig. 5 (a) is a drawing of the band when the concentration of Se is sharply increased in the interface region of the n-type Al_{0.1} Ga_{0.9} As layer within the n-type Al_{0.7} Ga_{0.3} As layer. Fig. 5 (b) is a drawing of the band when generated by supplying a constant amount of Se without regard to composition.
- Fig. 6: is a drawing of the major components making up the MOCVD apparatus for manufacturing the semiconductor laser of this invention.
- Fig. 7: is an angular view of the cross section of the semiconductor laser of the second embodiment of this invention.
- Figures 8 (a) and 8 (b): are drawings that show the cross sections of the manufacturing process of the semiconductor laser related to the second embodiment of this invention.
- Fig. 9: shows an angular view of a cross section of the semiconductor laser of the third embodiment of this invention.
- Figures 10 (a) through 10 (f): are drawings that show the cross sections of the manufacturing process of the third embodiment of this invention.
- Fig. 11: is a timing chart showing the changes in flow rate and the exposure of light on TMAI when growing the distributed Bragg reflection multiple layer mirror in the third embodiment of this invention.
- Fig. 12: is a drawing that shows the results of evaluating a portion of the distributed Bragg reflection multiple layer mirror in the third embodiment of this invention by means of the SIMS method (secondary ion mass spectrometry).
- Fig. 13: is an angular view of the cross section of the semiconductor laser before the improvements were added.

Below, the drawings will be used to describe the embodiments in order to provide a more detailed description of this invention.

### First Embodiment

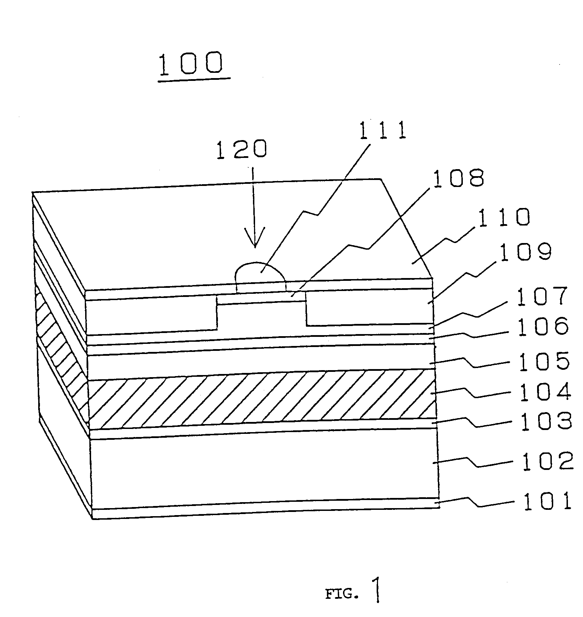

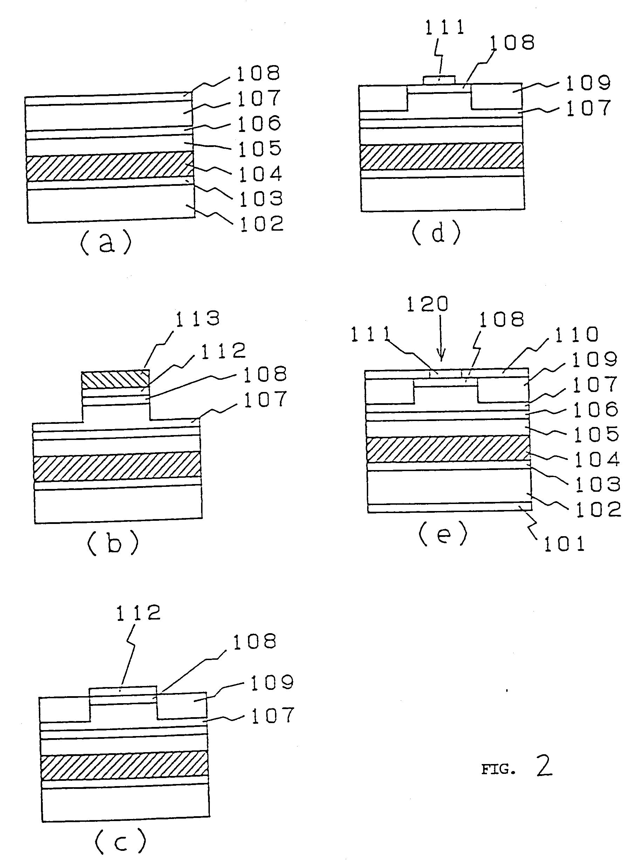

Fig. 1 shows an angular view of the cross section of the emission section of the semiconductor laser 100 of the first embodiment of this invention. Figures 2 (a) through 2 (e) show cross sections of the steps in the manufacturing process of the semiconductor laser of this embodiment. Below, Figures 2 (a) through 2 (e) will be used to describe the composition and manufacturing steps of the semiconductor laser 100 related to this invention.

(1) First of all, an n-type GaAs buffer layer 103 is formed on an n-type GaAs substrate 102. Next, 30 pairs of an n-type AI_{0.7} Ga_{0.3} As layer and an n-type Al_{0.1} Ga_{0.9} As layer will be formed to constitute a distributed Bragg reflection multiple layer mirror 104 having a reflection power of 98% or higher relative to light in the 870 nm wavelength region. Next, an n-type Al_{0.4} Ga_{0.6} As cladding layer 105 and a p-type GaAs active layer 106 and a p-type Al_{0.4} Ga_{0.6} As cladding layer 107 and an p-type Al_{0.1} Ga_{0.9} As contact layer 108 are formed in sequence by means of epitaxial growth using the MOCVD method (Fig. 2 (a)). In this embodiment, the epitaxial growth temperature is 700°C, the epitaxial growth pressure is 150 torr, and the group III materials are the organic metals TMGa (tri methyl gallium) and TMAI (tri methyl aluminum). The group V materials are AsH₃, the n-type dopant is H₂Se and the p-type dopant is DEZn (diethyl zinc).

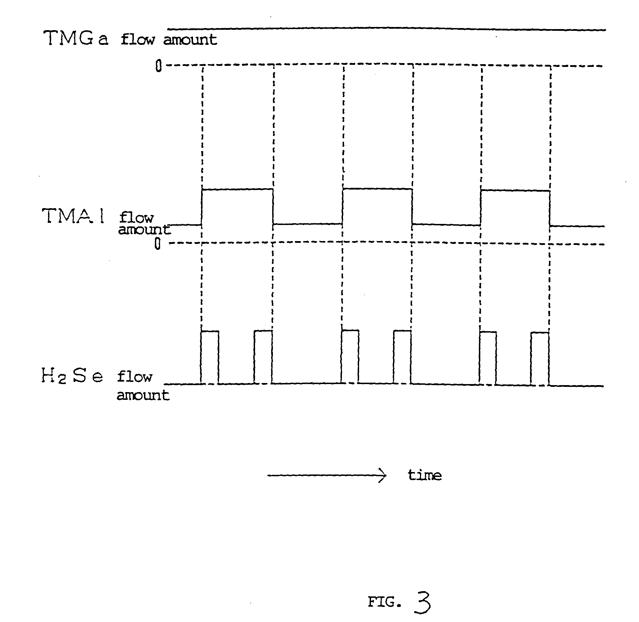

Now the manufacturing process steps of the aforesaid distributed Bragg reflection multiple layer mirror 104 will be described. Fig. 3 shows the changes in flow rates of TMGa and TMAI, which are the materials used when growing the distributed Bragg reflection multiple layer mirror, and the n-type dopant. Because the TMGa is being supplied at a constant rate, the rapidly growing section of TMAI flow forms the n-type Al_{0.7} Ga_{0.3} As layer and the slow growing section of the TMAI flow forms the n-type Al_{0.1} Ga_{0.9} As layer. Here, the thickness of each layer is controlled so that 1/4 of the wavelength of the 870 nm wavelength light propagates through the layer. In addition, at the same time, the high flow rate H₂Se section shows the growth portion in which the high concentration doping of the n-type carrier is desired, and the low flow rate H₂Se section shows the growth portion in which the low concentration doping of the n-type carrier is desired. As for the changing of the flow rate, in the MOCVD apparatus, the control of the amount of doping takes place at the desired interface by changing the high flow rate lines and low flow rate lines of the H₂Se flow by changing a computer controlled valve. In addition, in this embodiment, the highly H₂Se-doped section is such that it rises steeply relative to the TMAI high growth section, that is, in the interface region between the n-type Al_{0.1} Ga_{0.9} As layer and the n-type Al_{0.7} Ga_{0.3} As layer.

(2) After the growing of the epitaxial layers described above, an SiO₂ layer 112 is formed on the surface by means of the thermal CVD method. The column shaped portion that is covered with resist 113 is left by using the reactive ion beam etching method (called RIBE below). The partial etching of the cladding layer 107 (Fig. 2 (b)) takes place. At this time, a mixture of chlorine and argon gases is used in this embodiment as the etching gas. The gas pressure is 1 x 10⁻³ torr and the acceleration voltage is 400 volts. The purpose of the etching of cladding layer 107 up to the middle thereof is to provide a rib waveguide type refraction waveguide structure which can confine injected carriers and light rays in the active layer.

(3) Next, a buried layer is formed on the cladding layer 107. For this purpose, in this embodiment the resist 113 is first removed and then a ZnS_{0.06} Se_{0.94} layer 109 is buried using the MBE method or the MOCVD method.

(4) After this, the SiO₂ layer 112 is removed and four pairs of SiO₂ / a-Si layers constituting a dielectric multiple layer mirror are formed using electron beam deposition. Dry etching, which makes use of the reactive ion etching method (called the RIE method below), is used to leave and remove a region slightly smaller than the diameter of the emission section (Fig. 2 (d)). The reflection power of the dielectric multiple layer mirror is 94% at a wavelength of 870 nm.

(5) Next, a p-type ohmic electrode 110 is deposited on surfaces other than the dielectric multiple layer mirror and an n-type ohmic electrode 101 is deposited on the Ga As substrate 102 (Fig. 2 (e)). Finally, alloying at 400°C takes place in an N₂ atmosphere.

The surface emitting semiconductor laser 100 of this embodiment, which is manufactured in this manner, uses a ZnS_{0.06} Se_{0.94} layer as a burying layer. This layer has a resistance of one giga ohm or higher. Because there is no leakage of applied current to the burying layer 109, an extremely effective current constriction can be achieved. In addition, because the burying layer 109 is not required to have a multiple layer structure, it can be grown easily and has a high level of repeatability between batches.

Because this surface emitting semiconductor laser has a rib type waveguide structure, the difference in the refractive index of the active layer at the bottom of the ZnS_{0.06} Se_{O.94} layer and that of the active layer of the resonator sector increases, allowing an effective light enclosure to be accomplished simultaneously.

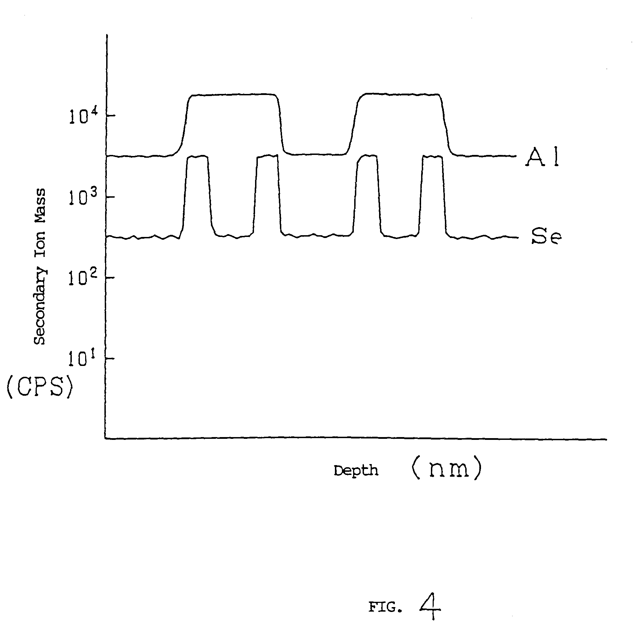

Here, the results of the evaluation of a portion of the distributed Bragg reflection multiple layer mirror using the SIMS (secondary ion mass spectrometry) method are shown in Fig. 4. In Fig. 4, the vertical line indicates the number of secondary ions of Al and Se. They correspond to the volume of atoms and number of carriers contained in the layer. The horizontal line indicates the depth in the film thickness direction in part of the distributed Bragg reflection multiple layer mirror.

If Fig. 4 and Fig. 3 are compared, the concentration of Se, which is an n-type dopant, increases sharply at the interface region of the n-type Al_{0.1} Ga_{0.9} As layer within the n-type Al_{0.7} Ga_{0.3} As layer, confirming that the desired amount of doping has taken place.

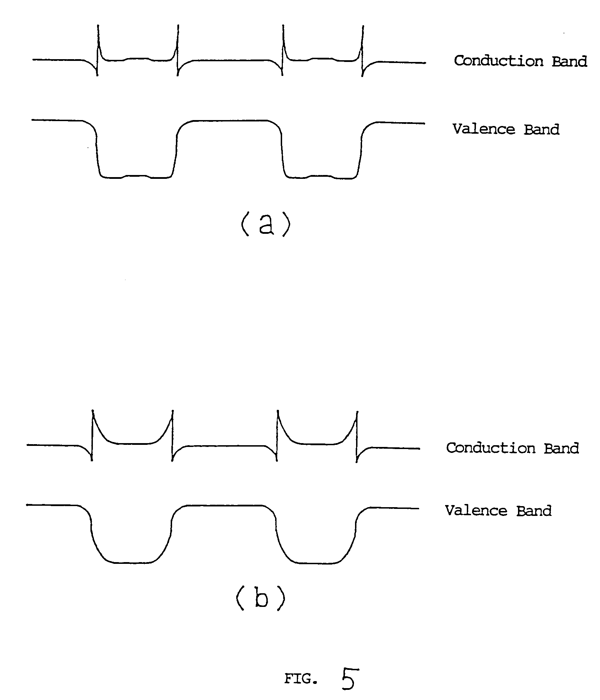

Next, the effectiveness of this invention will be described using the typical energy band drawings of the distributed Bragg reflection multiple layer mirror shown in Fig. 5. Fig. 5 (a) shows the case in which the concentration of the Se that was generated by means of this embodiment was increased sharply at the interface region of the n-type Al_{0.1} Ga_{0.9} As layer within the n-type Al_{0.7} Ga_{0.3} As layer. Fig. 5 (b) shows the case in which Se was generated and supplied in a constant volume in a low concentration, regardless of composition. In this embodiment, when both are compared, the walls of the conduction band become thin and the electrons are easily prone to tunnel conductance as a result of the increased carrier concentration in the interface region. Thus, it is understood that the resistance in the vertical direction will decrease in the multiple film layers.

In addition, because the only place where the carrier concentration has been increased by means of doping is the interface region of the layers, there is no deterioration in film quality due to the high concentration of dopant.

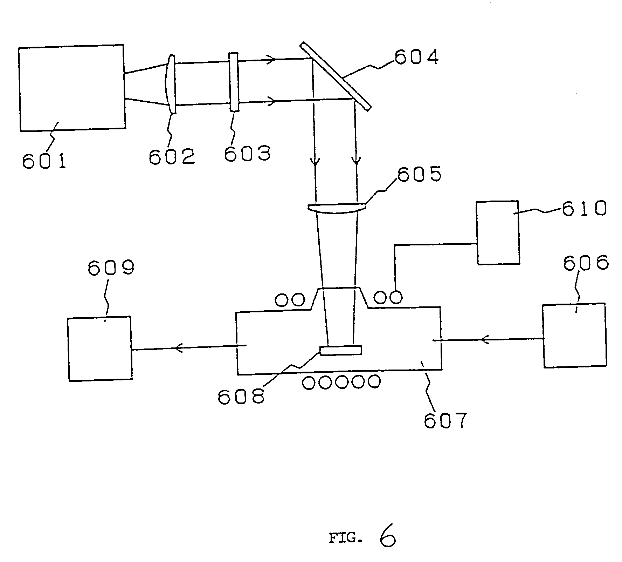

Fig. 6 shows a block diagram of the major components of the MOCVD apparatus used in the embodiment of this invention. In this apparatus, the material gas is put into the reaction tube 607 from the material gas introduction system 606 and this gas is allowed to flow onto a substrate 608 that has been heated by means of an RF oscillator 610 to grow the compound semiconductor thin film. The used material gas is discharged through the gas exhaust system 609. In addition, the material gas can be introduced instantaneously to the reaction tube 607 by means of a valve that is computer controlled. Moreover, the supply volume can be controlled to a desired volume through a mass flow controller (MFC). Although not used in this embodiment, this apparatus is equipped with an excimer laser 601. The ultraviolet light from the excimer laser 601 is collimated by means of the cylindrical lenses 602 and 603, reflected by a mirror 604 and then passed through a condenser lens 606, making it possible to project it onto the substrate during the growing process.

### Second Embodiment

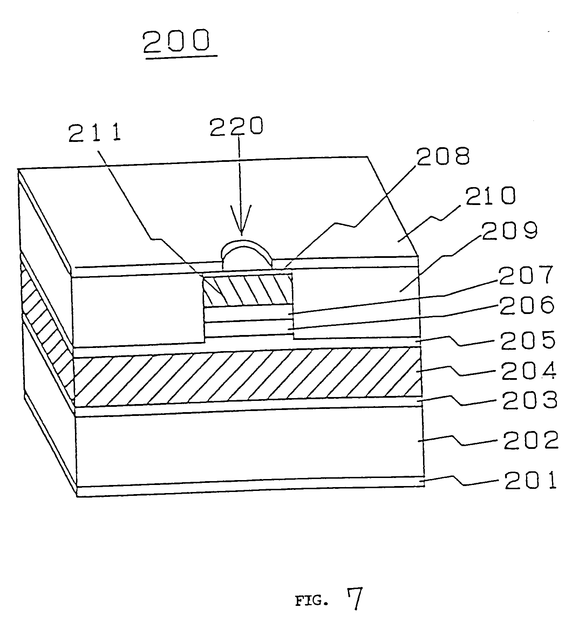

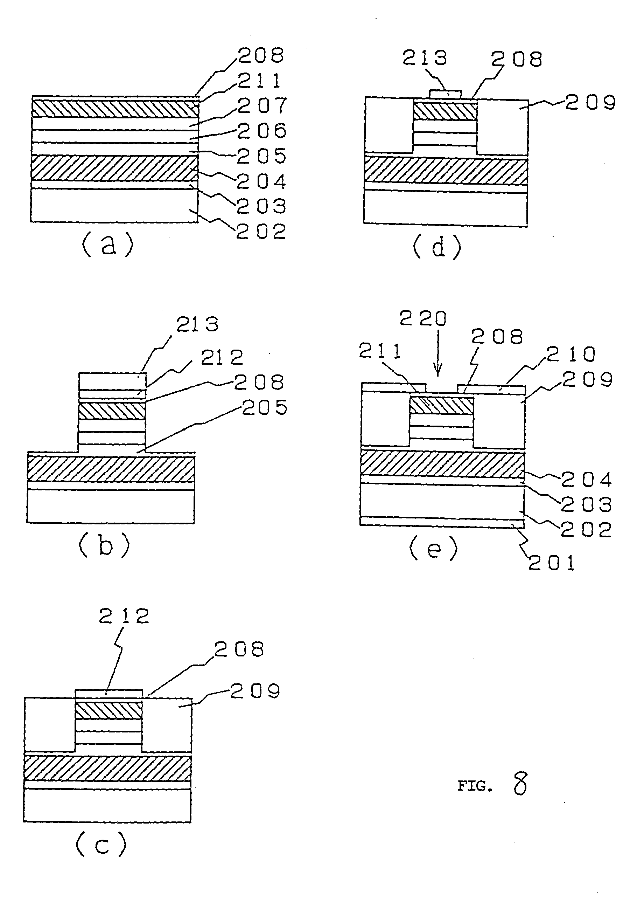

Fig. 7 is an angular view of the cross section of the emission section of the semiconductor laser 200 of the second embodiment of this invention. Figures 8 (a) through 8 (e) show cross sections of the manufacturing process steps of the semiconductor laser 200 of this embodiment.

The semiconductor laser 200 of the second embodiment differs from that of first embodiment described above in that the emission section is in part formed in the shape of a column from the p-type Al_{0.1} Ga_{0.9} As contact layer 208 to the Al_{0.4} Ga_{0.6} As cladding layer 205 and in that a distributed Bragg reflection multiple layer mirror 211 is formed on the p-type ohmic electrode 210. The composition and manufacturing process of this embodiment will be described below based on the drawings of Figures 8 (a) through 8 (e).

(1) First of all, an n-type GaAs buffer layer 203 is formed on an n-type GaAs substrate 202. Next, 30 pairs of an n-type AlAs layer and an n-type Al_{0.1} Ga_{0.9} As layer are formed to constitute a distributed Bragg reflection multiple layer mirror 204. The mirror has a reflection power of 98% or more relative to light with a wavelength in a vicinity of 870 nm. Next, an n-type Al_{0.4} Ga_{0.6} As cladding layer 205, a p-type GaAs active layer 206 and a p-type Al_{0.4} Ga_{0.6} As cladding layer 207 are formed in sequence. Next, 25 pairs of a p-type AlAs layer and a p-type Al_{0.1} Ga_{0.9} As layer are formed to constitute a distributed Bragg reflection multiple layer mirror 211. The mirror has a reflection power of 94% or more relative to light with a wavelength in a vicinity of 870 nm. On top of that, a p-type Al_{0.1} Ga_{0.9} As contact layer is grown by means of an epitaxial growing method to form this layer in sequence using the MOCVD method (Fig. 8 (a)). At this time, in this embodiment, the growth temperature is 700°C, the growth pressure is 150 torr, the group III materials are the organic metals TMGa (tri methyl gallium) and TMAI (tri methyl aluminum), the group V material is AsH₃, the n-type dopant is H₂Se, and the p-type dopant is DEZn (diethyl zinc).

In the fabrication of the aforesaid distributed Bragg reflection multiple layer mirror 211, the dopant concentration of the interface of the layers is increased by controlling the supply of H₂Se in the case of the distributed Bragg reflection multiple layer mirror 204 during the fabrication of the layer and by controlling the supply of DEZn in the case of the distributed Bragg reflection multiple layer mirror 211, as in the previously described first embodiment.

(2) Next, the RIBE method is used to leave a column shaped emission section that is covered with resist 213 and partial etching of the n-type Al_{0.4} Ga_{0.6} As cladding layer takes place (Fig. 8 (b)). At this time, in this embodiment a mixed gas of chlorine and argon is used as the etching gas. The gas pressure is 1 x 10⁻³ torr and the extraction voltage is 400 volts.

(3) Next, a buried layer will be formed in the etching region. For this purpose, in this embodiment the resist 213 will be removed and either the MBE method or the MOCVD method will be used to bury and grow a ZnS_{0.06} Se_{0.94} layer 209 (Fig. 8 (d)).

(4) The SiO₂ layer 212 will then be removed. Next, a region that is slightly smaller than the diameter of the emission section will be formed by using a resist on the surface of the contact layer.

(5) After this, a p-type ohmic electrode 210 will be deposited on the surface and the lift-off method will be used to open up a light exposure hole in the surface of the emission section. An n-type ohmic electrode 201 will be deposited on the GaAs substrate 202 (Fig. 8 (e)). Finally, alloying at 400°C will take place in a nitrogen atmosphere.

As shown in Fig. 7, it is possible to obtain a surface emitting semiconductor laser (200) with a buried structure by means of the process steps listed above.

The ZnS_{0.06} Se_{0.94} layer that is used for the buried layer in the surface emitting semiconductor laser 200 of this embodiment, which is fabricated as indicated, has a resistance of 1 giga ohm or higher. Because there is no current leakage to the burying layer 209, a very effective current constriction can be achieved. In addition, because the burying layer 209 is not required to be of a multiple layer structure, it can be grown easily, and it has a high level of repeatability between batches. Furthermore, because it uses a ZnS _{0.06} Se_{0.94} layer, which has a sufficiently small refractive index compared to GaAs, a more effective light enclosure is possible due to the buried type refractive index waveguide structure, in which the active layer 206 is buried.

Moreover, as a result of the increase in the carrier concentration of the interface region of the layers that compose the distributed Bragg reflection multiple layer mirror 211, the walls of the conduction band are thinner and the tunnel conductance of the electrons is easy. Further, the valence band is smoother and the holes conduct more easily, making it possible to understand that the electrical resistance will decrease in the vertical direction of the multiple film layers.

Because the interface regions between the layers are the only areas in which the carrier concentration has been increased through doping, there is no film quality deterioration due to high concentrations of dopants.

In this embodiment, when the relationship between the amount of doping and the resistance of the distributed Bragg reflection multiple layer mirror was examined, the relationship between the maximum value of the carrier concentration of the interface region and the minimum value of the carrier concentration of regions other than the interface region, the effects of the low resistance began to appear at 1.1 times. However, when increased by 100 times, the increase in the low resistance effect that was seen was not simply an enlargement of that ratio. When considering making the control of the supply volume easier, the optimum was to have a ratio of from 2 times to 20 times. Also, it was confirmed that the maximum value of the interface region carrier concentration had to be at 5 x 10⁰ cm⁻³ or lower. This was due to the fact that it was confirmed that the film quality would deteriorate if the concentration of Zn was increased higher than this and that the reflection power of the distributed Bragg reflection multiple layer mirror would deteriorate.

### Third Embodiment

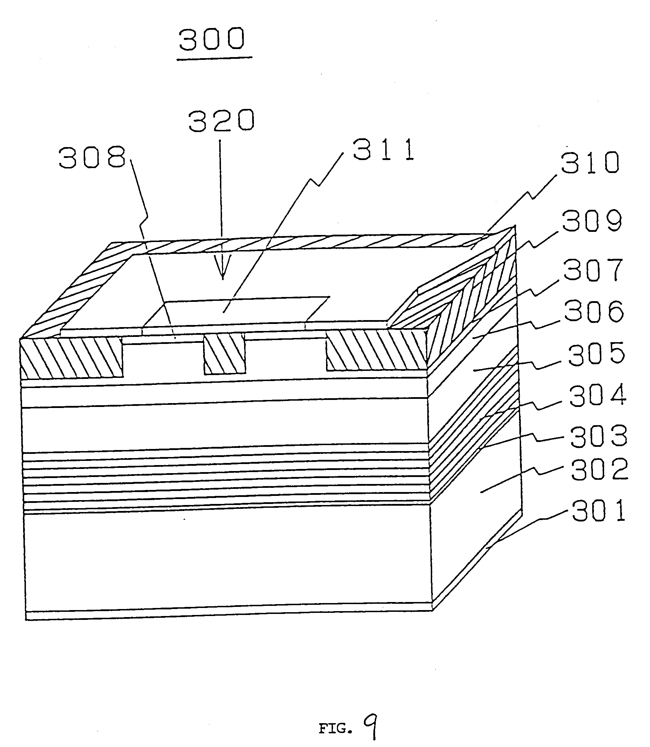

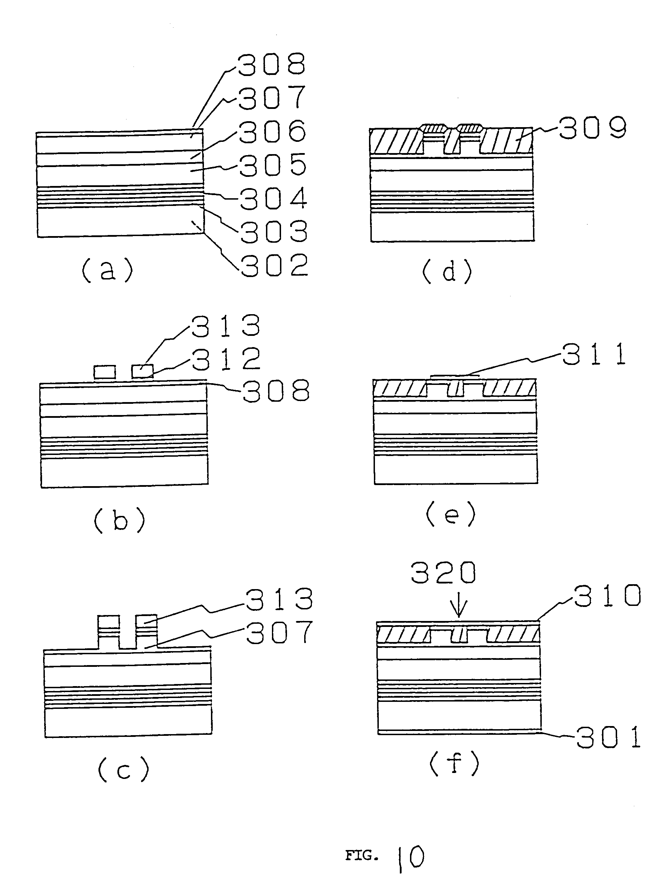

Fig. 9 shows an angular view of the cross section of the emission section of the semiconductor laser 300 of the third embodiment of this invention. Figures 10 (a) through 10 If) show the cross sections of the manufacturing process steps of the semiconductor laser 300 of this embodiment.

The semiconductor laser of this embodiment 300 differs from that of the first embodiment and the second embodiment described above in that it divides the p-type Al_{0.5} Ga_{0.5} As cladding layer 307 into a plurality of columns that are separated by separation grooves to form the emission section.

Below, the composition and the manufacturing process steps of this embodiment will be described using Figures 10 (a) through 10 (f).

(1) First of all, an n-type GaAs buffer layer 303 is formed on an n-type GaAs substrate 302. Next, 25 pairs of an n-type Al_{0.9} Ga_{0.1} As layer and an n-type Al_{0.2} Ga_{0.8} As layer are formed to constitute a semiconductor multiple layer mirror 304. The mirror has a reflection power of 98% or more relative to ± 30 nm light with a wavelength in the vicinity of 780 nm. Next, an n-type Al_{0.5} Ga_{0.5} As cladding layer 305, a p-type Al_{0.13} Ga_{0.87} As active layer 306, a p-type Al_{0.5} Ga_{0.5} As cladding layer 307 and a p-type Al_{0.15} Ga_{0.85} As contact layer are epitaxially grown in sequence using the MOCVD method (Fig. 10 (a)). In this embodiment, the conditions for epitaxial growth are a growth temperature of 720°C and a pressure of 150 torr. In addition, the group III materials used were the organic metals TMGa ( tri methyl gallium) and TMAI (tri methyl aluminum). The group V material was AsH₃, the n-type dopant used was TMSi (tetra methyl silane) and the p-type dopant used was DEZn (dimethyl zinc).

Here, the manufacturing process steps that accompany the exposure to light of the aforementioned distributed Bragg reflection multiple layer mirror 304 will be described in detail. Ultraviolet light will be used as the exposure light.

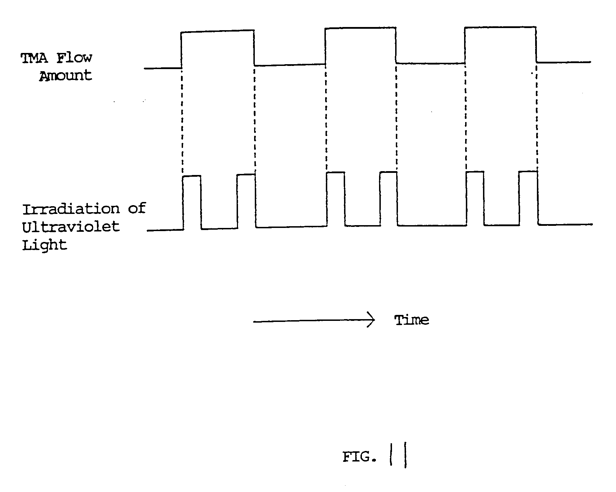

Fig. 11 is a timing chart of the changes in the amount of flow of TMAI and the exposure of light. TMAI is a base material of the distributed Bragg reflection multiple layer mirror. The area with the high TMAI flow rate forms the n-type Al_{0.9} Ga_{0.1} As layer. The area with the low TMAI flow rate forms the n-type Al_{0.2} Ga_{0.9} As layer. Here, the thickness of each layer is controlled so that it is 1/4 of the wavelength of the 780 nm wavelength light that propagates through the layer. In addition, in this embodiment, the exposure to ultraviolet light takes place at the growth area with the highest TMAI flow rate, that is, the interface region of the n-type Al_{0.2} Ga_{0.8} As layer which is in the n-type Al_{0.9} Ga_{0.1} As layer.

(2) Next, a SiO₂ layer 312 is formed on the surface using the atmospheric pressure CVD method. Photoresist is then applied on top of this layer to fabricate the required pattern using photolithography. At this time, the pattern conditions are such that the sides of the resist pattern is perpendicular to the surface of the substrate. After this patterning, heating that will cause the sagging of the sides does not take place.

(3) Next, this pattern is placed on a mask and reactive ion etching (RIE) takes place using CF₄ gas as the etching gas to remove the SiO₂ layer. Performing the operations for the required pattern as described above, it is possible to create the resist 313 with sides that are perpendicular relative to the substrate as well as create a pattern using the SiO₂ layer 312 (Fig. 10 (b)).

(4) Next, the resist 313 with the perpendicular sides will be made into a mask and etching will take place to leave a column shaped emission section using the RIBE method. At this time, the p-type Al_{0.5} Ga_{0.5} As cladding layer will be partially etched to form the intervals between the plurality of columns that form the emission section (Fig. 10 (c)). At this time, in this embodiment, a mixture of chlorine and argon gasses will be used as the etching gas. The gas pressure will be 5 x 10⁻⁴ torr. The plasma extraction voltage will be 400 volts. Based on the etching sample, the ion current density will be 400 µA per square centimeter, with the sample temperature being maintained at 20°C.

Here, the reason the p-type Al_{0.5} Ga_{0.5} As cladding layer 307 is only partially etched is to make the implanted carrier of the horizontal direction of the active layer and the light enclosure a refractive index waveguide type ribbed waveguide structure and allow the part of the light in the active layer to be able to transmit in the horizontal direction of the active layer.

In addition, by using a resist 313 with perpendicular sides and by using the RIBE method, which etches by projecting an ion beam that is perpendicular to the etching sample, as the etching method, it is possible to separate the neighboring emission sections 320 by means of a vertical groove 314 on the substrate as well as possible to fabricate the vertical optical resonator necessary to improve the characteristics of the surface emitting semiconductor laser.

(5) Next, a buried layer will be formed on this p-type Al_{0.5} Ga_{0.5} As cladding layer 307. For this purpose, in this embodiment, first of all, the resist 313 will be removed and a ZnS_{0.06} Se_{0.94} layer 309 will be buried using methods such as the MBE method or the MOCVD method (Fig. 10(d)).

(6) Next, the SiO₂ layer and the poly crystalline ZnSSe formed on top of it will be removed. Next, four pairs of SiO₂ / a-Si layers will be formed on the surface using electron beam deposition, to form a dielectric multiple layer reflection mirror 311. This will then be removed by dry etching that uses the RIE method so that an area slightly smaller than the diameter of the emission section is left (Fig. 10 (e)). The reflection power of the dielectric multiple layer mirror will be 95% or higher at a wavelength of 780 nm.

Because dielectric multiple layer mirror 311 is also fabricated in the separation grooves 314 that are buried in the ZnS_{0.06} Se_{0.94} layer of the semiconductor laser of this embodiment, a perpendicular resonator structure has also been formed for the constricted areas of the emission section. As a result, the light that leaks to the separation grooves contributes to the effectiveness of the laser oscillations. Moreover, because leaked light is being used, the emissions are synchronized with the phase of the emission section 320.

(7) After this, p-type ohmic electrodes 310 are deposited on surfaces other than the dielectric multiple layer mirror 311. In addition, an n-type ohmic electrode 301 is deposited on the substrate (Fig. 10 (f)). Here, the p-type ohmic electrode 310 of the irradiation side is fabricated so that it has continuity with each contact layer 308 of each emission section 320. Finally, alloying takes place at 400°C in a nitrogen atmosphere.

As indicated in Fig. 9, it is possible to obtain the surface emitting semiconductor laser 300 with an emission section 320 as described above.

Even the ZnS_{0.06} Se_{0.94} layer, which is used as the burying layer 309 in the surface emitting semiconductor laser 300 of this embodiment and is fabricated in this manner, has a resistance of one giga ohm or higher. Because there is no leakage of implant current to the burying layer 309, an extremely effective current constriction is possible. In addition, because it is not necessary to make the burying layer 309 a multiple of layers, this layer can be fabricated easily, with a high level of repeatability between batches. Moreover, because this surface emitting semiconductor laser has a rib type waveguide structure, there is a large difference in the refractive indices of the active layer below the ZnS_{0.06} Se_{0.94} layer and the activation resonator section, allowing the accomplishment of effective light enclosure at the same time.

Because dielectric multiple layer mirror 311 is also fabricated in the separation grooves 314 that are buried in the ZnS_{0.06} Se_{0.94} layer of the semiconductor laser of this embodiment, a perpendicular resonator structure has also been formed for the constricted areas of the emission section. As a result, the light that leaks to the separation grooves contributes to the effectiveness of the laser oscillations. Moreover, because leaked light is being used, the emissions are synchronized with the phase of the emission section 320.

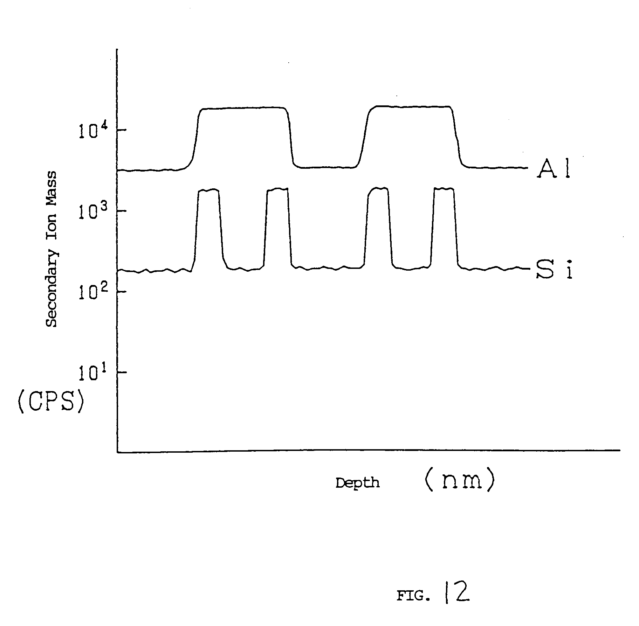

Here, the results of the evaluation of a portion of the distributed Bragg reflection multiple layer mirror using the SIMS (secondary ion mass spectrometry) method are shown in Fig. 12. In Fig. 12, the vertical line indicate the number of secondary ions of Al and Si. They correspond to the volume of atoms and number of carriers contained in the layer. The horizontal lines indicate the depth of the film thickness direction in part of the distributed Bragg reflection multiple layer mirror.

If Fig. 12 and Fig. 11 are compared, it is obvious that there is a sharp increase in the Si concentration, an n-type dopant, in the layer in which the ultraviolet light was projected, making it a layer with a high carrier concentration. This is due to the following reasons. That is, TMSi, which is a dopant material, is extremely stable thermally and undergoes thermal breakdown with difficulty. However, because the absorption band is in the ultraviolet region, it breaks down easily optically by being exposed to ultraviolet light. As a result, when comparing exposure to ultraviolet light to no exposure to ultraviolet light, with exposure to ultraviolet light the Si concentration of the growth layer rises sharply, having the practical effect of an increase in the supply of the n-type dopant.

In addition, as a result of the increase in the carrier concentration of the interface region of the layers that compose the distributed Bragg reflection multiple layer mirror 304, the walls of the conduction band become thin and the electrons undergo tunnel transfer easily. Therefore, there is a decrease in the electrical resistance in the vertical direction of the multiple layers. Also, because the only place that has an increase in carrier concentration due to the doping is the interface region and because the light irradiation contributes to the improvement of the film quality, there is no deterioration in film quality due to the high concentration of dopant.

The MOCVD apparatus used in this embodiment is the same as that shown in Fig. 6. Ultraviolet light is projected using an excimer laser 601.

In this embodiment, an example using tetra methyl silane has been indicated. However, this invention is not limited to this. The same effect can be obtained by using a material in which thermal breakdown is difficult, in which there is absorption in the short wavelength band and in which breakdown is easy using the short wavelength light. Examples of the type of materials that can be used are tetra isobutyl silicon (C₄ H₉)₄ Si, tri isobutyl silicon hydride (C₂ H₅)₃ SiH and tri ethyl silane (C₂ H₅)₃ SiH. However, because of things such as being easy to handle and due to its optical breakdown efficiency, tetra ethyl silane is desirable.

In this manner, although there are some restrictions in the dopant materials, the method of this embodiment does not cause any changes in the flow of gas during growth when the amount of dopant is changed. Therefore, an extremely uniform epitaxial layer is obtained, and this improves the properties and the yield of the elements.

In each of the embodiments described above, one manufacturing process was described for one structure. However, this invention is not limited to this. In addition, S, Se, Te, Si and Zn, C, Be, Mg and Ca can all be used effectively as dopants.

When using GaAs type materials such as Te or Mg, materials with low doping efficiency, the doping efficiency can be changed and effects that are equivalent to those described in the embodiments above can be obtained. This is accomplished by controlling the flow of As H₃, which is a group V material, at the location where the high dopant concentration is desired in order to change the V/III ratio, which is the ratio used with the group III material.

In all of the embodiments described above, an explanation of a GaAlAs type surface emitting semiconductor laser was given. However, this can also be applied well to other group III-V surface emitting semiconductor lasers. In particular, the oscillation wavelength of the active layer can be changed by changing the Al composition.

In addition, the buried layer is not limited to ZnSSe mixed crystal. An equivalent effect can be obtained with ZnS-ZnSe super lattice and other group Il-VI compound semiconductors. For example, the equivalent effects can be obtained with ZnSe or ZnS or CdTe and their mixed crystals, or super lattices based on these materials can also be selected for the buried layer.

Also, the substrate does not have to be GaAs. An equivalent effect can be obtained from semiconductor substrates such as Si and InP or from dielectric substrates such as sapphire.

In the embodiments described above, examples of increasing the carrier concentration of the interface region of the layer side with the large energy bandgap that composes the distributed Bragg reflection multiple layer mirror were given. However, this invention is not limited to this. The carrier concentration of the interface region of the layer with the small energy bandgap may also be increased. Or, the carrier concentration of the interface regions between both the layer with the large bandgap and the small energy bandgap may be increased.

In particular, when a detailed investigation was made of the distribution of the carrier concentration, the reflection power of the multiple layer film, the resistance and the multiple layer film crystal characteristics of the vertical direction of the multiple layer film, it was necessary to make the thickness of the interface region with the increase in carrier concentration by 1/3 of the thickness of both the layer with the large energy bandgap and that with the small energy bandgap. It was confirmed that the crystalline characteristics would deteriorate if the thickness was made greater than this.

Moreover, to accomplish low resistance, it is desirable to have an instantaneous change of the volume of high concentration dopant and the volume of low concentration dopant. However, a slight deterioration in crystalline characteristics was seen depending on the doping material. In this case, a sharp change in the amount of dopant volume does not take place. If a mass flow controller is used to make the change linearly or as a quadratic function or as a cubic function, in a time that is within 1/2 the time to dope the interface region, the low resistance effect will be reduced slightly. However, the crystal characteristics can be prevented from deteriorating.

As described in detail above, using this invention, a highly efficient highly reliable semiconductor laser can be offered by making it possible to easily and accurately control the concentration of dopant in the interface region of a distributed Bragg reflection multiple layer mirror composed of low resistance reflection mirror portions.

In addition, using the manufacturing process of this invention, it is possible to easily and accurately control the dopant concentration of the interface region of the distributed Bragg reflection multiple layer mirror portions. It is also possible to offer a surface emitting semiconductor laser with excellent characteristics and excellent yield.

The surface emitting semiconductor laser of this invention as describe above is not only applicable to printing apparatuses such as printers and copiers, it is also suitable as a light emission source for equipment such as facsimile machines, displays and telecommunications equipment.

## Claims

1. A surface emitting semiconductor laser that projects light in a direction perpendicular to a substrate main surface, comprising:
an optical resonator having a substrate side reflecting mirror (104; 204; 304), a surface side reflecting mirror (111; 211; 311) and between the reflecting mirrors a semiconductor layer arrangement (105, 106, 107) composed of at least one layer, the or at least one of the layers of the semiconductor layer arrangement forming one or more columns with a group II-VI compound semiconductor epitaxial layer (109; 209; 309) being buried around the one or more columns;
wherein the substrate side reflecting mirror (104; 204; 304) is a distributed Bragg reflection multiple layer mirror comprising alternately stacked first and second type layers of first and second group III-V compound semiconductors, respectively, wherein the second compound semiconductor has an energy bandgap larger than that of the first compound semiconductor, and a refractive index different from that of the first compound semiconductor;
**characterized in that**
the carrier concentration of the interface region between the first type layer and the second type layer is higher than that in the remaining regions of these layers in order to achieve tunnel conductance at the corresponding interface.

2. The laser of claim 1, wherein the surface side reflecting mirror (211) is a distributed Bragg reflection multiple layer mirror comprising alternately stacked third and fourth type layers of third and fourth group III-V compound semiconductors, respectively, wherein the fourth compound semiconductor has an energy bandgap larger than that of the third compound semiconductor, and a refractive index different from that of the third compound semiconductor, the carrier concentration of the interface region between the third type layer and the fourth type layer being higher than that in the remaining regions of these layers.

3. The laser of claim 2, wherein the first and the third compound semiconductor are the same and the second and the fourth compound semiconductor are the same.

4. The laser of either claim 1, 2 or 3, wherein the maximum value of the carrier concentration of said interface region is between a minimum of 1.1 times and a maximum of 100 times the value of said remaining regions.

5. The laser of claim 1, 2 or 3, wherein the maximum value of the carrier concentration of said interface region is 5 x 10⁰ cm⁻³ or less.

6. The laser of any one of the preceding claims, wherein the thickness of said interface region is within 1/3 of the total thickness of the two layers forming the interface.

7. The laser of any one of the preceding claims, wherein the dopants used to dope said interface region are selected from S, Se, Te and Si for an n-type region and from Zn, C, Be, Mg and Ca for a p-type region.

8. A process of manufacturing a laser as defined in claim 1, comprising the steps of:
(a) forming on a semiconductor or a dielectric substrate (102; 202; 302) the substrate side reflecting mirror (104; 204; 304) and the semiconductor layer arrangement (105, 106, 107; 205, 206, 207; 305, 306, 307) by means of a metal organic gas phase growth method or a molecular beam epitaxial growth method;
(b) forming a photoresist mask (113) on the semiconductor layers formed in step (a) and etching the or at least one layer of said semiconductor layer arrangement to form either one or a plurality of columns; and
(c) epitaxially growing a group II-VI compound semiconductor around the column or columns formed in step (b) to form a buried layer (109);
wherein, in step (a), when growing at least one of the interface regions between a first type layer and a second type layer of said reflecting mirror, the carrier concentration is increased so as to be higher than that of other regions by either increasing the amount of the material used for doping the interface regions or exposure to suitable light.

9. The process of claim 8 for manufacturing a laser as defined in claim 2, which further comprises forming of the surface side reflection mirror (211) and wherein when growing at least one of the interface regions between said first type layer and said second type layer or at least one of the interface regions between a third type layer and a fourth type layer of said surface side reflection mirror, the carrier concentration is increased so as to be higher than that of other regions by either increasing the amount of the material used for doping the interface regions or exposure to light.

10. The process of claim 8 or claim 9, wherein the supply of the material used for doping the interface region and the supply of the material used for doping regions other than the interface region are changed instantaneously.

11. The process of claim 8 or claim 9, wherein the supply of the material used for doping the interface region and the supply of the material used for doping regions other than the interface region are changed within half the total time for doping the interface region either linearly with or as a quadratic or cubic function of the time.

12. The process of claim 8 or claim 9, wherein, when increasing the carrier concentration is performed by exposure to light, tetramethylsilane is used as the doping material.

13. The process of any of claims 8 through claim 12 wherein the ratio of group III material and group V material is changed simultaneously when increasing the carrier concentration of said interface region.

14. The process of claim 8 or 9, wherein said exposure to light comprises exposure to ultraviolet light.

## Patentansprüche

1. Oberflächenemittierender Halbleiterlaser, der Licht in einer Richtung senkrecht zu einer Substrathauptfläche emittiert, umfassend:
einen optischen Resonator mit einem substratseitigen Reflexionsspiegel (104; 204; 304), einem oberflächenseitigen Reflexionsspiegel (111; 211; 311) und zwischen den Reflexionsspiegeln einer Halbleiterschichtanordnung (105, 106, 107) aus wenigstens einer Schicht, wobei die oder wenigstens eine der Schichten der Halbleiterschichtanordnung eine oder mehrere Säulen bildet und eine ll-VI-Verbindungshalbleiter-Epitaxialschicht (109; 209; 309) um die eine oder mehr Säulen vergraben ist,
wobei der substratseitige Reflexionsspiegel (104; 204; 304) ein Distributed-Bragg-Reflexions-Mehrschichtspiegel ist mit abwechselnd gestapelten Schichten eines ersten und eines zweiten Typs aus einem ersten bzw. zweiten III-V-Verbindungshalbleiter, wobei der zweite Verbindungshalbleiter einen Energiebandabstand aufweist, der größer ist als der des ersten Verbindungshalbleiters, und einen Brechungsindex, der anders ist als der des ersten Verbindungshalbleiters,
dadurch gekennzeichnet, daß
die Ladungsträgerkonzentration im Grenzschichtbereich zwischen der Schicht des ersten Typs und der Schicht des zweiten Typs höher ist als in den übrigen Bereichen dieser Schichten, damit eine Tunnelleitung an der entsprechenden Grenzschicht erzielt wird.

2. Laser nach Anspruch 1, bei dem der oberflächenseitige Reflexionsspiegel (211) ein Distributed-Bragg-Reflexions-Mehrschichtspiegel ist mit abwechselnd gestapelten Schichten eines dritten und eines vierten Typs aus dritten bzw. vierten III-V-Verbindungshalbleitern, wobei der vierte Verbindungshalbleiter einen Energiebandabstand größer als der des dritten Verbindungshalbleiters aufweist und einen von dem des dritten Verbindungshalbleiters verschiedenen Brechungsindex, wobei die Ladungsträgerkonzentration im Grenzschichtbereich zwischen der Schicht des dritten Typs und der Schicht des vierten Typs höher ist als in den übrigen Bereichen dieser Schichten.

3. Laser nach Anspruch 2, bei dem der erste und der dritte Verbindungshalbleiter dieselben sind und der zweite und der vierte Halbleiter dieselben sind.

4. Laser nach einem der Ansprüche 1, 2 oder 3, bei dem der Maximalwert der Ladungsträgerkonzentration im Grenzschichtbereich zwischen einem Minimum des 1,1 fachen und einem Maximum des 100 fachen des Werts der übrigen Bereiche ist.

5. Laser nach Anspruch 1, 2 oder 3, bei dem der Maximalwert der Ladungsträgerkonzentration in dem Grenzschichtbereich 5 x 10⁰ cm⁻³ oder weniger ist.

6. Laser nach einem der vorhergehenden Ansprüche, bei dem die Dicke des Grenzschichtbereichs innerhalb 1/3 der Gesamtdicke der beiden die Grenzschicht bildenden Schichten liegt.

7. Laser nach einem der vorhergehenden Ansprüche, bei die Dotierstoffe, die zum Dotieren des Grenzschichtbereichs verwendet werden, ausgewählt sind aus S, Se, Te und Si für einen n-leitenden Bereich und aus Zn, C, Be, Mg und Ca für einen p-leitenden Bereich.

8. Verfahren zur Herstellung eines Lasers, wie er im Anspruch 1 definiert ist, umfassend die Schritte:
(a) Ausbilden auf einem Halbleiter- oder einem dielektrischen Substrat (102; 202; 302) des substratseitigen Reflexionsspiegels (104; 204; 304) und der Halbleiterschichtanordnung (105, 106, 107; 205, 206, 207; 305, 306, 307) mittels eines metallorganischen Gasphasen-Wachstumsverfahrens oder eines Molekularstrahl-Epitaxialwachstumsverfahrens;
(b) Ausbilden einer Photoresistmaske (113) auf den im Schritt (a) ausgebildeten Halbleiterschichten und Ätzen der oder wenigstens einer Schicht der Halbleiterschichtanordnung zur Bildung entweder einer oder einer Mehrzahl von Säulen; und
(c) Epitaxiales Aufwachsen eines II-VI-Verbindungshalbleiters, um die im Schritt (b) gebildete Säule oder gebildeten Säulen zur Bildung einer vergrabenen Schicht (109);
wobei, im Schritt (a), wenn wenigstens einer der Grenzschichtbereiche zwischen einer Schicht des ersten Typs und einer Schicht des zweiten Typs des Reflexionsspiegels aufgewachsen wird, die Ladungsträgerkonzentration erhöht wird, um höher zu sein als die anderer Bereiche, indem entweder die Menge des zum Dotieren der Grenzschichtbereiche verwendeten Materials erhöht wird oder eine Belichtung mit geeignetem Licht erfolgt.

9. Verfahren nach Anspruch 8 zur Herstellung eines Lasers, wie er in Anspruch 2 definiert ist, das ferner das Ausbilden des oberflächenseitigen Reflexionsspiegels (211) umfaßt, und bei dem, wenn wenigstens einer der Grenzschichtbereich zwischen der Schicht des ersten Typs und der Schicht des zweiten Typs oder wenigstens einer der Grenzschichtbereiche zwischen einer Schicht eines dritten Typs und einer Schicht eines vierten Typs des oberflächenseitigen Reflexionsspiegels aufgewachsen wird, die Ladungsträgerkonzentration erhöht wird, um höher zu sein als diejenige anderer Bereiche, indem entweder die Menge des zum Dotieren der Grenzschichtbereiche verwendeten Materials erhöht wird oder eine Belichtung erfolgt.

10. Verfahren nach Anspruch 8 oder 9, bei dem die Zufuhr des zum Dotieren des Grenzschichtbereichs verwendeten Materials und die Zufuhr des zum Dotieren anderer Bereiche als des Grenzschichtbereichs verwendeten Materials plötzlich umgeschaltet werden.

11. Verfahren nach Anspruch 8 oder 9, bei dem die Zufuhr des zum Dotieren des Grenzschichtbereichs verwendeten Materials und die Zufuhr des zum Dotieren anderer Bereich als des Grenzschichtbereichs verwendeten Materials innerhalb der Hälfte der Gesamtzeit zum Dotieren des Grenzschichtbereichs entweder linear oder als eine quadratische oder kubische Funktion der Zeit umgeschaltet werden.

12. Verfahren nach Anspruch 8 oder 9, bei dem, wenn die Erhöhung der Ladungsträgerkonzentration mittels Belichtung ausgeführt wird, Tetramethylsilan als das Dotierungsmaterial verwendet wird.

13. Verfahren nach einem der Ansprüche 8 bis 12, bei dem das Verhältnis von Material der Gruppe III und Material der Gruppe V plötzlich geändert wird, wenn die Ladungsträgerkonzentration des Grenzschichtbereichs erhöht wird.

14. Verfahren nach Anspruch 8 oder 9, bei dem das Belichten ein Belichten mit ultraviolettem Licht umfaßt.

## Revendications

1. Laser à semi-conducteur à émission de surface qui projette de la lumière suivant une direction perpendiculaire à une surface principale d'un substrat, comprenant:
un résonateur optique ayant un miroir réfléchissant du côté du substrat (104; 204; 304), un miroir réfléchissant du côté de la surface (111; 211; 311) et, entre les miroirs réfléchissants, un agencement de couches semi-conductrices (105, 106, 107) composé d'au moins une couche, cette dite au moins une couche de l'agencement de couches semi-conductrices formant une ou plusieurs colonnes avec une couche épitaxiale semiconductrice d'un composé du groupe II-VI (109; 209; 309) qui est enterrée autour de la ou des colonne(s);
le miroir réfléchissant du côté du substrat (104; 204; 304) étant un miroir à couches multiples à réflexion de Bragg distribuée comprenant des couches empilées en alternance d'un premier et d'un second types constituées respectivement de premiers et seconds semi-conducteurs composés du groupe le second semi-conducteur composé ayant une bande interdite plus grande que celle du premier composé semi-conducteur, et un indice de réfraction différent de celui du premier semi-conducteur composé;
caractérisé en ce que
la concentration en porteurs de la région d'interface entre la couche du premier type et la couche du second type est supérieure à celle des régions restantes de ces couches afin de produire une conductance d'effet tunnel à l'interface correspondante.

2. Laser selon la revendication 1, dans lequel le miroir réfléchissant du côté de la surface (211) est un miroir multicouche à réflexion de Bragg distribuée comprenant des couches empilées en alternance d'un troisième et d'un quatrième types constituées respectivement d'un troisième et d'un quatrième semi-conducteurs composés du groupe III-V, le quatrième semi-conducteur composé ayant une bande interdite supérieure à celle du troisième semi-conducteur composé, et un indice de réfraction différent de celui du troisième semi-conducteur composé, la concentration en porteurs de la région d'interface entre la couche du troisième type et la couche du quatrième type étant supérieure à celle des régions restantes de ces couches.

3. Laser selon la revendication 2, dans lequel les premier et troisième semi-conducteurs composés sont identiques et dans lequel les second et quatrième semi-conducteurs composés sont identiques.

4. Laser selon l'une quelconque des revendications 1, 2 ou 3, dans lequel la valeur maximale de la concentration en porteurs de la région d'interface est comprise entre un minimum de 1,1 fois et un maximum de 100 fois la valeur des régions restantes.

5. Laser selon l'une quelconque des revendications 1, 2 ou 3, dans lequel la valeur maximale de la concentration en porteurs de la région d'interface est de 5x10⁰ cm⁻³ ou moins.

6. Laser selon l'une quelconque des revendications précédentes, dans lequel l'épaisseur de la région d'interface est inférieure à 1/3 de l'épaisseur totale des deux couches formant l'interface.

7. Laser selon l'une quelconque des revendications précédentes, dans lequel les dopants utilisés pour doper la région d'interface sont sélectionnés parmi S, Se, Te et Si pour une région de type n et parmi Zn, C, Be, Mg et Ca pour une région de type p.

8. Procédé de fabrication d'un laser selon la revendication 1, comprenant les étapes qui consistent:
(a) à former, sur un semi-conducteur ou un substrat diélectrique (102; 202; 302) le miroir réfléchissant du côté du substrat (104; 204; 304) et l'agencement de couches semi-conductrices (105, 106, 107; 205, 206, 207; 305, 306, 307) par un procédé de croissance aux organométalliques en phase gazeuse ou un procédé de croissance épitaxiale par faisceaux moléculaires;
(b) à former un masque de vernis photosensible (113) sur les couches semi-conductrices formées lors de l'étape la) et à attaquer la couche au nombre d'au moins un de l'agencement de couches semi-conductrices pour former soit une, soit plusieurs colonnes; et
(c) à faire croître par épitaxie un semi-conducteur composé du groupe II-VI autour de la colonne ou des colonnes formée(s) lors de l'étape (b) pour former une couche enterrée (109);
dans lequel, lors de l'étape (a), lorsqu'on fait croître au moins l'une des régions d'interface entre une couche du premier type et une couche du second type du miroir réfléchissant, la concentration en porteurs est augmentée de façon à être supérieure à celle d'autres régions soit par augmentation de la quantité du matériau utilisé pour doper les régions d'interface, soit par exposition à une lumière appropriée.

9. Procédé selon la revendication 8 pour fabriquer un laser selon la revendication 2, qui comprend en outre la formation du miroir réfléchissant du côté de la surface (211) et dans lequel, lorsqu'on fait croître au moins l'une des régions d'interface entre la couche du premier type et la couche du second type, ou au moins l'une des régions d'interface entre une couche du troisième type et une couche du quatrième type du miroir réfléchissant du côté de la surface, la concentration en porteurs est augmentée de façon à être supérieure à celle d'autres régions soit par augmentation de la quantité du matériau utilisé pour doper les régions d'interface, soit par exposition à de la lumière.

10. Procédé selon la revendication 8 ou 9, dans lequel la fourniture du matériau utilisé pour doper la région d'interface et la fourniture du matériau utilisé pour doper des régions autres que la région d'interface, sont modifiées instantanément.

11. Procédé selon la revendication 8 ou 9, dans lequel la fourniture du matériau utilisé pour doper la région d'interface et la fourniture du matériau utilisé pour doper des régions autres que la région d'interface, sont modifiées en moins de la moitié du temps total nécessaire pour doper la région d'interface, soit linéairement, soit selon une fonction quadratique ou cubique en fonction du temps.

12. Procédé selon la revendication 8 ou 9, dans lequel, lorsqu'on augmente la concentration en porteurs par exposition à de la lumière, on utilise du tétraméthylsilane en tant que matériau de dopage.

13. Procédé selon l'une quelconque des revendications 8 à 12, dans lequel le rapport du matériau du groupe III au matériau du groupe V est modifié en même temps que l'augmentation de la concentration en porteurs de la région d'interface.

14. Procédé selon la revendication 8 ou 9, dans lequel l'exposition à de la lumière comprend une exposition à de la lumière ultraviolette.
